Europäisches Patentamt

European Patent Office

Office européen des brevets

(19)

(11) EP 0 772 764 B1

(12) **EUROPÄISCHE PATENTSCHRIFT**

(45) Veröffentlichungstag und Bekanntmachung des Hinweises auf die Patenterteilung:
**14.01.1998 Patentblatt 1998/03**

(21) Anmeldenummer: **96904042.7**

(22) Anmeldetag: **09.02.1996**

(51) Int Cl.⁶: **G01H 3/08**, G10L 3/00

(86) Internationale Anmeldenummer:
**PCT/EP96/00550**

(87) Internationale Veröffentlichungsnummer:
**WO 96/25649 (22.08.1996 Gazette 1996/38)**

(54) **VERFAHREN UND VORRICHTUNG ZUM BESTIMMEN DER TONALITÄT EINES AUDIOSIGNALS**

PROCESS AND DEVICE FOR DETERMINING THE TONALITY OF AN AUDIO SIGNAL

PROCEDE ET DISPOSITIF POUR LA DETERMINATION DE LA TONALITE D'UN SIGNAL BASSE FREQUENCE

(84) Benannte Vertragsstaaten:
**AT BE CH DE DK FR GB IE IT LI NL SE**

(30) Priorität: **17.02.1995 DE 19505435**

(43) Veröffentlichungstag der Anmeldung:
**14.05.1997 Patentblatt 1997/20**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
* **HERRE, Jürgen**
  **D-91054 Buckenhof (DE)**
* **EBERLEIN, Ernst**
  **D-91091 Grossenseebach (DE)**
* **GRILL, Bernhard**
  **D-91207 Lauf (DE)**
* **BRANDENBURG, Karlheinz**
  **D-91054 Erlangen (DE)**
* **GERHÄUSER, Heinz**
  **D-91344 Waischenfeld (DE)**

(74) Vertreter: **Schoppe, Fritz, Dipl.-Ing. et al Patentanwalt,**
**Postfach 71 08 67**
**81458 München (DE)**

(56) Entgegenhaltungen:
**EP-A- 0 446 037**

* **SIGNAL PROCESSING, Bd. 13, Nr. 1, Juli 1987, AMSTERDAM NL, Seiten 15-28, XP002007372 T.FUNADA: "A method for the extraction of spectral peaks and its application to fundamental frequency estimation of speech signals"**
* **INTERNATIONAL JOURNAL OF ELECTRONICS, Bd. 73, Nr. 6, Dezember 1992, LONDON GB, Seiten 1185-1199, XP000332180 S.A.HANNA: "Frequency-domain maximum likelihood pitch determination approach"**
* **PHILIPS TELECOMMUNICATION REVIEW, Bd. 49, Nr. 1, 1.März 1991, HILVERSUM NL, Seiten 19-27, XP000227060 ARMBRUSTER W ET AL: "HANDS-FREE TELEPHONY, SPEECH RECOGNITION AND SPEECH CODING TECHNIQUES IMPLEMENTED IN THE SPS51"**
* **ICASSP 85 PROCEEDINGS, 26. - 29.März 1985, TAMPA FLORIDA, Seiten 415-418, XP002007373 H.INDEFREY E.A.: "Design and evaluation of double-transform Pitch determination algorithms with nonlinear distorsion in the frequency domain - Preliminary results"**

**Beschreibung**

Die vorliegende Erfindung befaßt sich mit einem Verfahren und einer Vorrichtung zum Bestimmen der Tonalität eines Audiosignals.

Die Gehör-angepaßte Codierung und Datenreduktion von Audiosignalen beruht darauf, daß die bei der Codierung entstehenden Codierungsfehler spektral so geformt werden, daß sie unterhalb der sogenannten Mithörschwelle zu liegen kommen und damit unhörbar bleiben. Damit kommt der Bestimmung der momentanen Mithörschwelle bei der Codierung eines Audiosignales bzw. innerhalb eines Coders eine entscheidende Rolle zu.

Die Abschätzung der Mithörschwelle wird üblicherweise mittels eines Gehörmodells, das als "Perceptual Model" bezeichnet wird, vorgenommen. Das Audioeingangssignal wird einerseits diesem sogenannten "Perceptual Model" bzw. Gehörmodell zugeführt und andererseits nach einer Transformation mittels einer Filterbank oder einer blockweise durchgeführten Frequenztransformation einer Quantisierungs/Codierungs-Stufe zugeführt, die durch das Ausgangssignal des Gehörmodells bzw. des Perceptual Models angesteuert wird.

Hierbei spielt es für die Maskierungsfähigkeit eines Signales eine Rolle, ob ein tonartiges oder tonales Signal oder ein mehr rauschartiges oder nicht-tonales Signal vorliegt, da rauschartige Signale eine erheblich stärkere Maskierungswirkung für Codierungsfehler besitzen als tonale Signalkomponenten. Hierzu wird verwiesen auf R.P. Hellman: "Asymmetry of Masking between Noise and Tone", Perception and Psychophysics, Band 11, Seiten 241 - 246, 1972.

Aus diesem Grunde beinhalten gängige psychoakustische Modelle, wie beispielsweise die im ISO/MPEG-Standard beschriebenen Modelle (vergleiche ISO/IEC 11172-3, Annex D) bereits Mechanismen zur Detektion von tonalen Signalkomponenten. Beispielsweise wird in dem dort beschriebenen "psychoakustischen Modell 1" eine Signalkomponente als "tonal" eingestuft, wenn sie pegelmäßig um einen gewissen Faktor (7 dB) stärker ist als die sie umgebenden Frequenzlinien. Im "psychoakustischen Modell 2" wird eine Bestimmung der Tonalität aufgrund einer Prädiktion von komplexen FFT-Zeigern durchgeführt, die bei tonalen Signalen im Idealfall nur kleine Prädiktionsfehler aufweist. Hieraus wird auf die Tonalität der Signalkomponente geschlossen.

Diese beiden bekannten Verfahren ermöglichen jedoch nur eine unzuverlässige Detektion der Tonalität.

Ausgehend von diesem Stand der Technik liegt der vorliegenden Erfindung die Aufgabe zugrunde, ein Verfahren und eine Vorrichtung zum Bestimmen der Tonalität eines Audiosignales zu schaffen, welche eine erhöhte Zuverlässigkeit bei der Erfassung der Tonalität eines Signals haben.

Diese Aufgabe wird durch ein Verfahren bzw. durch eine Vorrichtung zum Bestimmen der Tonalität eines Audiosignales nach den unabhängigen Ansprüchen gelöst.

Gemäß einem ersten Aspekt schafft die Erfindung ein Verfahren zum Bestimmen der Tonalität eines Audiosignales mit folgenden Schritten: blockweises Frequenztransformieren eines digitalen Eingangssignales $x(n)$ zum Erzeugen einer reellen positivwertigen Darstellung $X(k)$ des Eingangssignales, wobei $k$ den Index einer Frequenzlinie bezeichnet, und Bestimmen der Tonalität $T$ der Signalkomponente bei der Frequenzlinie $k$ gemäß folgender Gleichung:

$$T(k) = \frac{F_1[X]\,(k+d_1)}{F_2[X]\,(k+d_2)},$$

wobei $F_1$ die Filterfunktion eines ersten digitalen Filters mit einer ersten, differenzierenden Charakteristik ist, wobei $F_2$ die Filterfunktion eines zweiten digitalen Filters mit einer zweiten, flachen oder integrierenden oder mit gegenüber der ersten Charakteristik weniger stark differenzierender Charakteristik ist, und wobei $d_1$ und $d_2$ ganzzahlige Konstanten sind, die in Abhängigkeit von den Filterparametern so gewählt sind, daß die jeweiligen Verzögerungen der Filter kompensiert werden.

Gemäß einem zweiten Aspekt schafft die Erfindung ein Verfahren zum Bestimmen der Tonalität eines Audiosignales mit folgenden Schritten: blockweises Frequenztransformieren eines ersten Eingangssignales $x(n)$ zum Erzeugen einer reellen positivwertigen Darstellung $X(k)$ des Eingangssignales, wobei $k$ den Index einer Frequenzlinie bezeichnet, und Bestimmen der Tonalität $T$ der Signalkomponente bei der Frequenzlinie $k$ gemäß folgender Gleichung:

$$T(k) = F[\log[X]](k+d),$$

wobei $F$ die Filterfunktion eines digitalen Filters mit differenzierender Charakteristik ist, und wobei $d$ eine ganzzahlige Konstante ist, die so gewählt ist, daß die Verzögerung des Filters kompensiert wird.

Gemäß einem dritten Aspekt schafft die Erfindung eine Vorrichtung zum Bestimmen der Tonalität eines Audiosignales mit einer Transformationseinrichtung zum blockweisen Frequenztransformieren eines digitalen Eingangssignales $x(n)$ zum Erzeugen einer reellen positivwertigen Darstellung $X(k)$ des Eingangssignales, wobei $k$ den Index der Frequenzlinie bezeichnet, zwei digitalen Filtern mit Filterfunktionen $F_1$, $F_2$, wobei $F_1$ die Filterfunktion des ersten digitalen Filters mit einer ersten, differenzierenden Charakteristik ist und $F_2$ die Filterfunktion des zweiten digitalen Filters mit einer flachen oder intergrierenden oder gegenüber der ersten Charakteristik weniger stark differenzierenden Charakteristik ist, und einer Einrichtung zum Bestimmen der Tonalität $T$ der Signalkomponente bei der Frequenzlinie $k$ gemäß folgender Gleichung:

$$T(k) = \frac{F_1[X]\,(k+d_1)}{F_2[X]\,(k+d_2)},$$

wobei $d_1$ und $d_2$ ganzzahlige Konstanten sind, die so gewählt sind, daß die jeweiligen Verzögerungen der Filter kompensiert werden.

Gemäß einem vierten Aspekt schafft die Erfindung eine Vorrichtung zum Bestimmen der Tonalität eines Audiosignales mit einer Transformationseinrichtung zum blockweisen Frequenztransformieren eines digitalen Eingangssignales x(n) zum Erzeugen einer reellen positivwertigen Darstellung X(k) des Eingangssignales, wobei k den Index einer Frequenzlinie bezeichnet, einem digitalen Filter mit der Filterfunktion F, die eine differenzierende Charakteristik ist, und einer Einrichtung zum Bestimmen der Tonalität T der Signalkomponente bei der Frequenzlinie k gemäß folgender Gleichung:

$$T(k) = F[\log[X]](k+d),$$

wobei d eine ganzzahlige Konstante ist, die in Abhängigkeit von den Filterparametern des Filters F so gewählt ist, daß die Verzögerung des Filters F kompensiert wird.

Bevorzugte Ausführungsformen des erfindungsgemäßen Verfahrens werden nachfolgend unter Bezugnahme auf die Zeichnungen näher erläutert. Es zeigen:

Fig. 1    ein Blockdiagramm einer ersten Ausführungsform einer erfindungsgemäßen Vorrichtung zum Bestimmen der Tonalität eines Audiosignals; und

Fig. 2    ein Blockdiagramm einer zweiten Ausführungsform einer Vorrichtung zum Bestimmen der Tonalität eines Audiosignales.

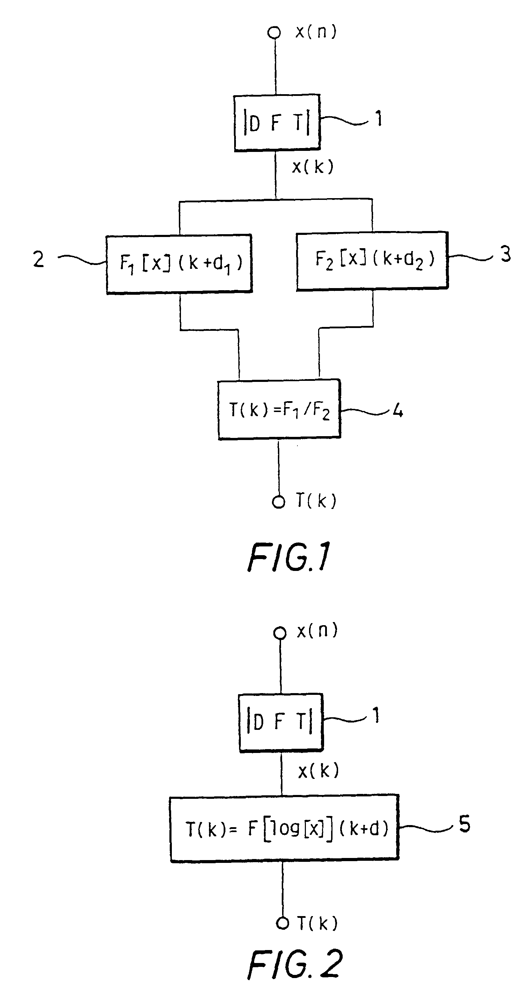

Wie in Fig. 1 gezeigt ist, wird ein digitales Eingangssignal x (n) zunächst mittels einer Frequenztransformation, die beispielsweise durch eine Berechnungsvorrichtung 1 zur Durchführung der diskreten Frequenztransformation und nachfolgender Betragsbildung implementiert sein kann, blockweise in eine reelle positivwertige spektrale Betragsdarstellung X(k) gebracht, wobei k der Index der Frequenzlinie ist.

Neben der Betragsbildung der Amplituden des DFT-Spektrums eignet sich zum Gewinnen der Betragsdarstellung auch die Verwendung der Betragsquadrate oder eine andere, Energieerhaltende Transformation.

Ausgehend von dieser Betragsdarstellung oder Energiedarstellung des diskreten Eingangssignals im Frequenzbereich sieht die vorliegende Erfindung zwei Berechnungskonzepte für die Ermittlung der Tonalität T(k) der Signalkomponente bei der Frequenzlinie mit dem Index k vor:

Bei der ersten Ausführungsform, die nunmehr unter Bezugnahme auf Fig. 1 erläutert wird, wird die Betragsdarstellung X(k) zwei digitalen Filtern 2, 3 zugeführt, wobei das erste Filter 2 eine Filterfunktion $F_1$ mit differenzierender Charakteristik hat. Das zweite Filter 3 hat im bevorzugten, einfachen Fall eine triviale Filterfunktion, d.h. eine mit der Eingangsgröße übereinstimmende Ausgangsgröße.

Durch ganzzahlige Konstanten $d_1$, $d_2$ werden bei beiden Filtern die Verzögerungen kompensiert. Diese Konstanten hängen, wie an sich im Bereich des Entwurfes digitaler Filter bekannt ist, von den gewählten Filterparametern ab.

Eine Quotientenbildungsschaltung 4 verknüpft die Ausgangswerte der beiden digitalen Filter 2, 3 durch Quotientenbildung, wodurch die Gesamtberechnungsvorrichtung ausgehend von der spektralen Betragsdarstellung X(k) durch folgende Gleichung die Tonalität T(k) der k-ten Signallinie folgendermaßen berechnet:

$$T(k) = \frac{F_1[X]\,(k+d_1)}{F_2[X]\,(k+d_2)}$$

Bei der beschriebenen bevorzugten Ausführungsform handelt es sich bei den verwendeten Filtern um sogenannte FIR-Filter, also um sogenannte "Finite Impulse Response"-Filter mit symmetrischer Impulsantwort. Das erste Filter hat, wie bereits erwähnt, eine differenzierende Filterfunktion $F_1$, d.h. es überträgt hochfrequente Komponenten bevorzugt.

Die Charakteristik des zweitgenannten Filters 3 kann neben der als bevorzugt angesehenen trivialen Charakteristik ($F_2[X] = 1$) auch eine summierende oder integrierende Charakteristik sein. Zwingend ist, daß die Charakteristik des ersten Filters 2 stärker differenzierend als diejenige des zweiten Filters 3 ist.

In Abweichung zu der unter Bezugnahme auf Fig. 1 beschriebenen Ausführungsform kann der Tonalitätswert T(k) auch durch die in Fig. 2 gezeigte weitere Ausführungsform der Vorrichtung zum Bestimmen der Tonalität eines Audiosignales ermittelt werden.

Der Block 1 dieser Vorrichtung stimmt mit dem Block 1 der Vorrichtung gemäß Fig. 1 überein und bildet die spektrale Betragsdarstellung X(k) durch blockweise, diskrete Fourier-Transformation des Eingangssignales x(n).

Eine Berechnungsvorrichtung 5 für die Bestimmung der Tonalität T(k) der k-ten Signalkomponente ermittelt die Tonalität aufgrund folgenden Zusammenhanges:

$$T(k) = F[\log[X]](k+d).$$

Auch hier bezeichnet die Konstante d einen ganzzahligen Wert zum Kompensieren der Verzögerung des Filters, der auch hier von den gewählten Filterparametern abhängt. Die bevorzugte Ausführungsform für das digitale Filter ist auch hier ein FIR-Filter mit symmetrischer Impulsantwort. Das Filter F weist eine differenzierende Charakteristik auf, d.h. es überträgt hochfrequente Komponenten bevorzugt.

Für den Fachmann ist es offenkundig, daß die durch die erfindungsgemäßen Verfahren und Vorrichtungen gewonnenen Tonalitätswerte T(k) rohe Werte sind, die mittels einer geeigneten nicht-linearen Anpassungsfunktion an das jeweils verwendete psychoakustische Modell angepaßt werden können, auch wenn dies nicht als zwingend angesehen wird. Auch die direkte Verwendung dieser Tonalitätswerte zur Ermittlung der Maskierungswirkung des Eingangssignales ist möglich.

**Patentansprüche**

1. Verfahren zum Bestimmen der Tonalität eines Audiosignales, mit folgenden Schritten:

   - blockweises Frequenztransformieren eines digitalen Eingangssignales x(n) zum Erzeugen einer reellen positivwertigen Darstellung X(k) des Eingangssignales, wobei k den Index einer Frequenzlinie bezeichnet, und

   - Bestimmen der Tonalität T der Signalkomponente bei der Frequenzlinie k gemäß folgender Gleichung:

   $$T(k) = \frac{F_1[X]\,(k+d_1)}{F_2[X]\,(k+d_2)},$$

   wobei $F_1$ die Filterfunktion eines ersten digitalen Filters mit einer ersten, differenzierenden Charakteristik ist,

   wobei $F_2$ die Filterfunktion eines zweiten digitalen Filters mit einer zweiten, flachen oder integrierenden oder mit gegenüber der ersten Charakteristik weniger stark differenzierender Charakteristik ist, und

   wobei $d_1$ und $d_2$ ganzzahlige Konstanten sind, die in Abhängigkeit von den Filterparametern so gewählt sind, daß die jeweiligen Verzögerungen der Filter kompensiert werden.

2. Verfahren zum Bestimmen der Tonalität eines Audiosignales, mit folgenden Schritten:

   - blockweises Frequenztransformieren eines Eingangssignales x(n) zum Erzeugen einer reellen positivwertigen Darstellung X(k) des Eingangssignales, wobei k den Index einer Frequenzlinie bezeichnet, und

   - Bestimmen der Tonalität T der Signalkomponente bei der Frequenzlinie k gemäß folgender Gleichung:

   $$T(k) = F[\log[X]](k+d),$$

   wobei F die Filterfunktion eines digitalen Filters mit differenzierender Charakteristik ist, und

   wobei d eine ganzzahlige Konstante ist, die so gewählt ist, daß die Verzögerung des Filters kompensiert wird.

3. Vorrichtung zum Bestimmen der Tonalität eines Audiosignales, mit folgenden Merkmalen:

   - einer Transformationseinrichtung (1) zum blockweisen Frequenztransformieren eines digitalen Eingangssignales x(n) zum Erzeugen einer reellen positivwertigen Darstellung X(k) des Eingangssignales, wobei k den Index der Frequenzlinie bezeichnet,

   - zwei digitalen Filtern (2, 3) mit Filterfunktionen $F_1$, $F_2$, wobei $F_1$ die Filterfunktion des ersten digitalen Filters mit einer ersten, differenzierenden Charakteristik ist und $F_2$ die Filterfunktion des zweiten digitalen Filters mit einer flachen oder intergrierenden oder gegenüber der ersten Charakteristik weniger stark differenzierenden Charakteristik ist, und

   - einer Einrichtung zum Bestimmen der Tonalität T der Signalkomponente bei der Frequenzlinie k gemäß folgender Gleichung:

   $$T(k) = \frac{F_1[X]\,(k+d_1)}{F_2[X]\,(k+d_2)},$$

   wobei $d_1$ und $d_2$ ganzzahlige Konstanten sind, die so gewählt sind, daß die jeweiligen Verzögerungen der Filter kompensiert werden.

4. Vorrichtung zum Bestimmen der Tonalität eines Audiosignales, mit folgenden Merkmalen:

   - einer Transformationseinrichtung (1) zum blockweisen Frequenztransformieren eines digitalen Eingangssignales x(n) zum Erzeugen einer reellen positivwertigen Darstellung X(k) des Eingangssignales, wobei k den Index einer Frequenzlinie bezeichnet,

   - einem digitalen Filter mit der Filterfunktion F, die eine differenzierende Charakteristik hat, und

- einer Einrichtung (5) zum Bestimmen der Tonalität T der Signalkomponente bei der Frequenzlinie k gemäß folgender Gleichung:

$$T(k) = F[\log[X]](k+d),$$

wobei d eine ganzzahlige Konstante ist, die in Abhängigkeit von den Filterparametern des Filters F so gewählt ist, daß die Verzögerung des Filters F kompensiert wird.

5. Verfahren nach Anspruch 1 oder 2, gekennzeichnet

daß bei dem Schritt des blockweise Frequenztransformierens eine reelle Betragsdarstellung X(k) des Eingangssignales gebildet wird.

6. Vorrichtung nach Anspruch 3 oder 4, dadurch gekennzeichnet,

daß die Transformationseinrichtung die reelle Betragsdarstellung X(k) der Frequenztransformierten des digitalen Eingangssignales bildet.

7. Vorrichtung nach Anspruch 3, dadurch gekennzeichnet,

daß das erste und das zweite digitale Filter (2, 3) als FIR-Filter ausgeführt sind.

8. Vorrichtung nach Anspruch 4, dadurch gekennzeichnet,

daß das Filter F als FIR-Filter ausgebildet ist.

**Claims**

1. Method for determining the tonality of an audio signal, with the following steps:

- blockwise frequency transforming of a digital input signal x(n) to create a real positive-value representation X(k) of the input signal, where k designates the index of a frequency line, and

- determining of the tonality T of the signal component for the frequency line k according to the following equation:

$$T(k) = \frac{F_1[X]\,(k+d_1)}{F_2[X]\,(k+d_2)}$$

where $F_1$ is the filter function of a first digital filter with a first, differentiating characteristic,

where $F_2$ is the filter function of a second digital filter with a second, flat or integrating characteristic or with a characteristic which is less strongly differentiating than the first characteristic, and

where $d_1$ and $d_2$ are integer constants which, depending on the filter parameters, are so chosen that the delays of the filters are compensated for in each case.

2. Method for determining the tonality of an audio signal, with the following steps:

- blockwise frequency transforming of a digital input signal x(n) to create a real positive-value representation X(k) of the input signal, where k designates the index of a frequency line, and

- determining of the tonality T of the signal components for the frequency line k according to the following equation:

$$T(k) = F[\log[X]](k+d),$$

where F is the filter function of a digital filter with differentiating characteristic, and

where d is an integer constant which is so chosen that the delay of the filter is compensated for.

3. Device for determining the tonality of an audio signal, with the following features:

- a transformation unit (1) for the blockwise frequency transforming of a digital input signal x(n) to create a real positive-value representation X(k) of the input signal, where k designates the index of the frequency line,

- two digital filters (2, 3) with filter functions $F_1$, $F_2$, where $F_1$ is the filter function of the first digital filter with a first, differentiating characteristic and $F_2$ is the filter function of the second digital filter with a flat or integrating characteristic or with a characteristic which is less strongly differentiating than the first characteristic, and

- a unit for determining the tonality T of the signal component for the frequency line k according to the following equation:

$$T(k) = \frac{F_1[X]\,(k+d_1)}{F_2[X]\,(k+d_2)}$$

where $d_1$ and $d_2$ are integer constants which are so chosen that the delays of the filters are compensated for in each case.

4. Device for determining the tonality of an audio signal, with the following features:

   - a transformation unit (1) for the blockwise frequency transforming of a digital input signal x(n) to create a real positive-value representation X(k) of the input signal, where k designates the index of a frequency line,

   - a digital filter with the filter function F, which has a differentiating characteristic, and

   - a unit (5) for determining the tonality T of the signal component for the frequency line k according to the following equation:

   $$T(k) = F[\log[X]](k+d),$$

   where d is an integer constant which, depending on the filter parameters of the filter F, is so chosen that the delay of the filter F is compensated for.

5. Method according to claim 1 or 2, characterized in

   that in the step of blockwise frequency transforming a real value representation X(k) of the input signal is formed.

6. Device according to claim 3 or 4, characterized in that the transformation unit forms the real value representation X(k) of the frequency transformed value of the digital input signal.

7. Device according to claim 3, characterized in

   that the first and second digital filters (2, 3) are implemented as FIR filters.

8. Device according to claim 4, characterized in

   that the filter F is implemented as an FIR filter .

**Revendications**

1. Procédé pour la détermination de la tonalité d'un signal audio, aux étapes suivantes consistant à:

   - transformer en bloc la fréquence d'un signal d'entrée numérique x(n), afin de générer une représentation en valeur positive réelle X(k) du signal d'entrée, k désignant l'indice d'une ligne de fréquence, et

   - déterminer la tonalité T de la composante de signal à la ligne de fréquence k selon l'équation suivante:

   $$T(k) = \frac{F_1[X]\,(k+d_1)}{F_2[X]\,(k+d_2)},$$

   $F_1$ étant la fonction de filtre d'un premier filtre numérique à première caractéristique différenciatrice,
   $F_2$ étant la fonction de filtre d'un second filtre numérique à seconde caractéristique plane ou intégrante ou moins fortement différenciatrice par rapport à la première caractéristique, et
   $d_1$ et $d_2$ étant des constantes de nombre entier choisies, en fonction des paramètres de filtre, de telle manière que les retards correspondants des filtres sont compensés.

2. Procédé pour la détermination de la tonalité d'un signal audio, aux étapes suivantes consistant à:

   - transformer en bloc la fréquence d'un signal d'entrée x(n), afin de générer une représentation en valeur positive réelle X(k) du signal d'entrée, k désignant l'indice d'une ligne de fréquence, et

   - déterminer la tonalité T de la composante de signal à la ligne de fréquence k selon l'équation suivante:

   $$T(k) = F[\log[X]](k+d),$$

   F étant la fonction de filtre d'un filtre numérique à caractéristique différenciatrice, et
   d étant une constante de nombre entier choisie de telle manière que le retard du filtre est compensé.

3. Dispositif pour la détermination de la tonalité d'un signal audio, aux caractéristiques suivantes:

   - un dispositif de transformation (1) destiné à transformer en bloc la fréquence d'un signal d'entrée numérique x(n), afin de générer une représentation en valeur positive réelle X(k) du signal d'entrée, k désignant l'indice de la ligne de fréquence,

   - deux filtres numériques (2, 3) à fonctions de filtre F1, F2, F1 étant la fonction de filtre du premier filtre numérique à première caractéristique différenciatrice et $F_2$ étant la fonction de filtre du second filtre numérique à caractéristique plane ou intégrante ou moins fortement différenciatrice par rapport à la première caractéristique, et

- un dispositif destiné à déterminer la tonalité T de la composante de signal à la ligne de fréquence k selon l'équation suivante:

$$T(k) = \frac{F_1[X]\,(k+d_1)}{F_2[X]\,(k+d_2)},$$

$d_1$ et $d_2$ étant des constantes de nombre entier choisies de telle manière que les retards correspondants des filtres sont compensés.

4. Dispositif pour la détermination de la tonalité d'un signal audio, aux caractéristiques suivantes:

- un dispositif de transformation (1) destiné à transformer en bloc la fréquence d'un signal d'entrée numérique x(n), afin de générer une représentation en valeur positive réelle X(k) du signal d'entrée, k désignant l'indice d'une ligne de fréquence,
- un filtre numérique à la fonction de filtre F, qui a une caractéristique différenciatrice, et
- un dispositif (5) destiné à déterminer la tonalité T de la composante de signal à la ligne de fréquence k selon l'équation suivante:

$$T(k) = F[\log[X]]\,(k+d),$$

d étant une constante de nombre entier choisie, en fonction des paramètres de filtre du filtre F, de telle manière que le retard du filtre F est compensé.

5. Procédé suivant la revendication 1 ou 2, caractérisé par le fait qu'à l'étape de transformation en bloc de la fréquence est formée une représentation de montant réelle X(k) du signal d'entrée.

6. Dispositif suivant la revendication 3 ou 4, caractérisé par le fait que le dispositif de transformation forme la représentation de montant réelle X(k) de la transformation en fréquence du signal d'entrée numérique.

7. Dispositif suivant la revendication 3, caractérisé par le fait que le premier et le second filtre numérique (2, 3) sont réalisés sous forme de filtres FIR.

8. Dispositif suivant la revendication 4, caractérisé par le fait que le filtre F est réalisé sous forme de filtre FIR.

x(n)

$|DFT|$ — 1

x(k)

2 — $F_1[x](k+d_1)$    $F_2[x](k+d_2)$ — 3

$T(k)=F_1/F_2$ — 4

T(k)

## FIG.1

x(n)

$|DFT|$ — 1

x(k)

$T(k)=F[log[x]](k+d)$ — 5

T(k)

## FIG.2